# EUROPEAN PATENT SPECIFICATION

(11) **EP 0 309 543 B1**
(45) Date of publication and mention of the grant of the patent: **04.08.1993**
(21) Application number: 88903615.8
(22) Date of filing: 23.03.1988
(51) Int. Cl.: H01L 23/44

(54) **LIQUID IMMERSION COOLING ASSEMBLY FOR INTEGRATED CIRCUITS**
FLÜSSIGKEITSTAUCHKÜHLEINRICHTUNG FÜR INTEGRIERTE SCHALTUNGEN
DISPOSITIF DE REFROIDISSEMENT PAR IMMERSION DANS UN LIQUIDE POUR DES CIRCUITS INTEGRES

(30) Priority: 16.04.1987 US 39056
(43) Date of publication of application: 05.04.1989
(73) Proprietor: NCR INTERNATIONAL INC., Dayton, Ohio 45479 (US)
(72) Inventor: LAUFFER, Donald, Keith, Poway, CA 92064 (US); SANWO, Ikuo, Jimmy, San Marcos, CA 92069 (US); TIPON, Donald, Greathouse, San Diego, CA 92129 (US)
(74) Representative: Robinson, Robert George
(86) International application number: PCT/US88/00932
(87) International publication number: WO 88/08204

(56) References cited:
- GB-A- 1 035 905
- US-A- 4 279 127
- Proceedings of the 8th international Cryogenic Engineering Conference, 3-6 June 1980, vol. ICEC-8 (Genova, IT), R.W.Guernsey: "Cryogenic for superconducting computers", see pages 534-537
- IBM Technical Disclosure Bulletin, vol. 25, no. 7B, December 1982 (Armonk, New York, US), I. Ames et al.: "Interface passivation structure for replaceable chip connection connection", see pages 3782-3783
- IBM Journal of Research and Development vol. 24, no. 2, Marsh 1980 (New York, US), A.V. Brown: "An overview of Josephon packaging", see pages 167-171

## Description

This invention relates generally to an integrated circuit packaging assembly.

More specifically, this invention provides a means and a method of mounting an integrated circuit package which may have at least 100 pins, and which in some instances may have upwards of 200 pins, within a cryogenic vessel filled with a liquefied gas for cooling purposes and/or performance enhancement. It also provides a means and a method for plugging and unplugging the integrated circuit package with ease at room temperatures, yet provides for a sound, reliable electrical and mechanical connection at cryogenic temperatures. A means is provided to thermally isolate the immersed circuit from the outside temperature by using a vacuum insulation vessel with carbon leads that thermally isolate the interconnections.

US Patent 4 279 127 discloses a superconducting electronic device immersed in an electrically non-conductive liquefied gas and a pair of leads connected to the device passing through the wall of the container for the liquefied gas. The ease with which the device can be connected to circuitry outside the liquefied gas is disadvantageously restricted. Also, if the device takes the form of an integrated circuit having a large number of leads, problems are likely to be experienced due to the conduction of heat away from the device via the leads connected thereto.

It is an object of the present invention to provide a cryogenic packaging assembly which permits easy insertion and removal of an integrated circuit package to and from a circuit board, which package may have a large plurality of connection pins, without prejudicing the thermal insulation between the package and external circuitry to which it is connected.

Thus, according to the invention, there is provided an integrated circuit packaging assembly including an integrated circuit package having a plurality of electrical pins and immersed in an electrically non-conductive liquefied gas having a temperature lower than the solidification temperature of mercury and provided in a thermally insulating vessel, and connecting means for electrically coupling said circuit package to, and thermally insulating said package from, circuitry external of said vessel, wherein said connecting means includes a low thermal conductivity, electrically conductive, material filling each one of a plurality of openings extending through said vessel and corresponding in number with the number of electrical pins of said integrated circuit package, a plurality of mating pins each having one end embedded in material contained in a respective opening and an opposite end disposed inside said vessel and having a cup portion receiving a respective one of said plurality of electrical pins, said electrical pins being held in said cup portions by mercury solidified at the low temperature of said liquefied gas, and a plurality of electrically conductive connector pins each embedded at one end in said material and projecting outwardly from said vessel for contact in a pin grid array socket to facilitate the electrical connection of said integrated circuit assembly to a printed circuit board.

The invention is advantageous in that it provides for a means of plugging-in and unplugging a multi-pin, "Pin Grid Array (PGA) Package" into a socket with zero force at room temperature and that will provide a solid reliable electrical and mechanical interconnection at cryogenic temperatures below minus 38.80°C using mercury (Hg) as a solder material. Also, the invention provides for a means of connecting an integrated circuit package located in a cold cryogenic temperature to a room temperature printed circuit board assembly using a high electrical conductivity yet low thermal conductivity medium such as carbon to minimize thermal conduction out of the cryogenic chamber through the electrical interconnection. Further, the invention advantageously provides for a protective enclosure for the cryogenic package.

One embodiment of the invention will now be described, by way of example, with reference to the accompanying drawings, in which:-
Fig. 1 is a full sectional view of the integrated circuit packaging assembly according to the invention.
Fig. 2 is an enlarged view of a portion of the assembly of Fig. 1.

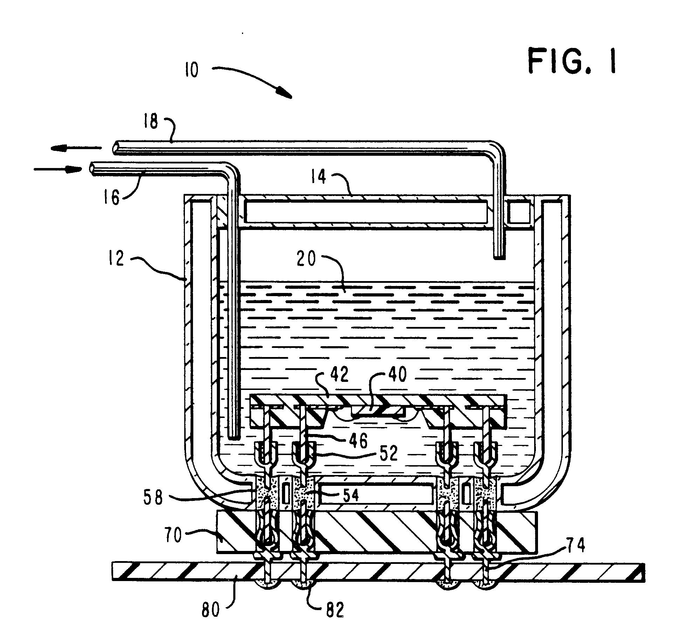

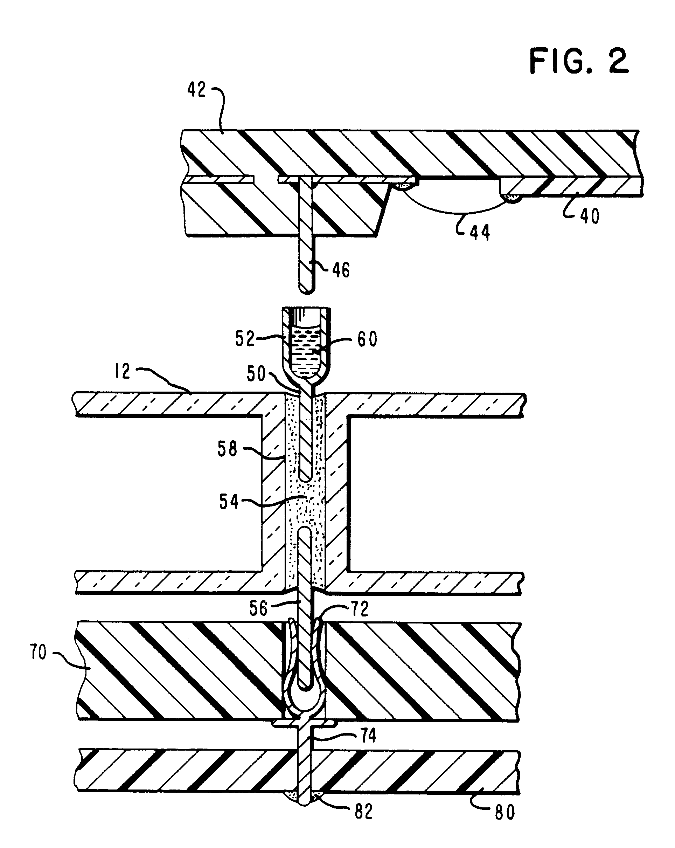

Referring to Figs. 1 and 2, the integrated circuit packaging assembly is shown generally as item 10 and includes a vessel 12 which may be a Dewar vessel having a closed but removable top 14 into which vessel is placed a low temperature liquefied gas 20 such as nitrogen, Freon, argon or helium to form a cryogenic chamber. Within the vessel 12 is positioned an IC chip 40 mounted on a carrier 42 to form a package having electrical conductors 44 and a plurality of electrical connecting pins 46. A corresponding plurality of openings 58 are formed through the wall of the vessel 12. A corresponding number of pins 50, each having an open receiver portion 52 shaped as a cup, are embedded in an electrically conductive and thermally insulating material 54 which fills the openings 58. The open cup portions 52 are partially filled with mercury 60. The material 54 may be carbon which functions as a buffer medium to minimize thermal conduction out of the cryogenic chamber through the electrical interconnections. A corresponding plurality of electrical connector pins 56 are inserted into the carbon material and extend outwards from the vessel 12. These connector pins are configured and positioned so as to mate with the connector pins 72 mounted in a receiving socket 70. Each of the pins 72 has a projecting portion 74 designed to mate with conductors on a PC board 80 and to be soldered to a conductor at 82.

To insert the electrical pins 46 of the integrated circuit package into the open cup portions 52 with a zero force, the temperature of the mercury 60 is raised to a temperature above minus 38.80°C since the mercury in the cup portions 52 of the pins 50 is in a liquid state at these temperatures. The integrated circuit package 40 can then either be inserted and/or removed and a new integrated circuit package inserted without the necessity of unsoldering all of the conductors. Once the integrated circuit package 40 is in place, the temperature is lowered causing the mercury to solidify, thus forming an electrical and mechanical connection similar to that of tin/lead eutectic solder. The tube 18 extending through the top of 14 of the vessel 12 is used to take off the liquefied gas commonly called the boil-off so that the gas can be reprocessed to form it back into a liquid and to reinject it, via the tube 16, back into the vessel 12.

## Claims

1. An integrated circuit packaging assembly (10) including an integrated circuit package (40,42,44) having a plurality of electrical pins (46), a thermally insulating vessel with an electrically non-conductive liquefied gas (20) having a temperature lower than the solidification temperature of mercury therein, said integrated circuit package being immersed in said liquefied gas, and connecting means (54,56) for electrically coupling said circuit package (40,42,44) to, and thermally insulating said package from, circuitry (80) external of said vessel, wherein said connecting means (54,56) includes a low thermal conductivity, electrically conductive, material (54) filling each one of a plurality of openings (58) extending through said vessel (12) and corresponding in number with the number of electrical pins (46) of said integrated circuit package (40,42,44), a plurality of mating pins (50) each having one end embedded in the material (54) contained in a respective opening (58) and an opposite end disposed inside said vessel (12) and having a cup portion (52) receiving a respective one of said plurality of electrical pins (46), said electrical pins (46) being held in said cup portions (52) by mercury solidified at the low temperature of said liquefied gas (20), and a plurality of electrically conductive connector pins (56) each embedded at one end in said material (54) and projecting outwardly from said vessel (12) for contact in a pin grid array socket (70,72,74) to facilitate the electrical connection of said integrated circuit assembly to a printed circuit board.

2. An assembly according to claim 1, characterized in that said low thermal conductivity, electrically conductive, material (54) is carbon.

3. An assembly according to claim 1 or 2, characterized in that said pin grid array socket (70,72,74) includes a plurality of receiving pins each having a portion (72) for receiving a corresponding connector pin (56) and a projecting portion (74) arranged to be connected and soldered (82) to respective conductors on said printed circuit board (80).

4. An assembly according to claim 1, 2 or 3, characterized in that said vessel is a Dewar vessel (12) having a removable top (14) and in which said liquefied gas (20) covers said integrated circuit package (40,42,44,46) and the mercury (60) contained in said cup portions (52).

5. An assembly according to claim 1, 2, 3 or 4, characterized in that the number of electrical pins (46) of said integrated circuit package is at least 100.

6. An assembly according to claim 5, characterized in that the number of electrical pins (46) of said integrated circuit package is at least 200.

7. An assembly according to any one of the preceding claims, characterized in that said liquefied gas is selected from nitrogen, Freon, argon and helium.

8. A method of mounting an integrated circuit package (40,42,44,46) in an integrated circuit packaging assembly (10) according to any one of claims 1 to 7, characterized by inserting each pin (46) of said integrated circuit package (40,42,44,46) into liquid mercury (60) contained in the cup portion (52) of a respective mating pin (50), and solidifying the liquid mercury (60) by immersing said integrated circuit package (40,42,44,46) and the mercury-containing cup portions (52) in said liquefied gas (20) so as to bond rigidly each pin (46) of said integrated circuit package (40,42,44,46) to a respective mating pin (50).

9. A method of removing an integrated circuit package (40,42,44,46) from an integrated circuit packaging assembly (10) according to any one of claims 1 to 7, characterized by increasing the temperature within said vessel (12) so as to liquefy the mercury (60) contained in each cup portion (52) to permit removal of each pin (46) of said integrated circuit package (40,42,44,46) from the cup portion (52) of a respective mating pin (50).

## Patentansprüche

1. Eine Packungsanordnung (10) für eine integrierte Schaltung mit einer IC-Packung (40,42,44), die aufweist: eine Vielzahl elektrischer Anschlußstifte (46), ein thermisch isolierendes Gefäß mit elektrisch nicht-leitendem, verflüssigtem Gas (20), dessen Temperatur unter der Erstarrungstemperatur von Quecksilber liegt und die IC-Packung in dem verflüssigten Gas eingetaucht ist und Verbindungseinrichtungen (54,56), um die Schaltungspackung (40,42,44) mit einer Schaltungsanordnung (80) außerhalb des Gefäßes elektrisch zu koppeln und die Packung thermisch davon zu isolieren, wobei die Verbindungseinrichtung (54,56) ein elektrisch leitendes Material (54) mit niedriger Wärmeleitfähigkeit umfaßt, das jede einzelne einer Vielzahl von sich durch das Gefäß (12) hindurcherstreckenden Öffnungen (58) ausfüllt, deren Anzahl mit der Anzahl elektrischer Anschlußstifte (46) der IC-Packung (40,42,44) übereinstimmt, eine Vielzahl von Gegenstiften (50), von denen jeweils ein Ende in das in einer jeweiligen Öffnung (58) enthaltene Material (54) eingebettet ist und ein gegenüberliegendes Ende innerhalb des Gefäßes (12) angeordnet ist und einen Becherabschnitt (52) zur Aufnahme von jeweils einem der Vielzahl elektrischer Anschlußstifte (46), wobei die elektrischen Anschlußstifte (46) durch mit der niedrigen Temperatur des verflüssigten Gases (20) verfestigtes Quecksilber in den Becherabschnitten (52) gehalten werden, und eine Vielzahl elektrisch leitender Verbinderstifte (56), die jeweils an einem Ende in das Material (54) eingebettet sind und aus dem Gefäß (12) zum Anschluß in einer Stiftgitteranordnungsbuchse (70,72,74) herausragen, um den elektrischen Anschluß der integrierten Schaltungsanordnung an eine gedruckte Schaltungsplatine zu erleichtern.

2. Anordnung nach Anspruch 1, dadurch gekennzeichnet, daß das elektrisch leitende Material (54) mit niedriger Wärmeleitfähigkeit Kohlenstoff ist.

3. Anordnung nach Anspruch 1 oder 2, dadurch gekennzeichnet, daß die Stiftgitteranordnungsbuchse (70,72,74) eine Vielzahl empfangender Stifte mit jeweils einem Abschnitt (72) zur Aufnahme eines entsprechenden Verbinderstiftes (56) und einen herausragenden Abschnitt (74) aufweist, der angeordnet ist, um an die jeweiligen Leiter auf der gedruckten Schaltungsplatine (80) angeschlossen und angelötet (82) zu werden.

4. Anordnung nach Anspruch 1, 2 oder 3, dadurch gekennzeichnet, daß das Gefäß ein Dewar-Gefäß (12) mit abnehmbarem Deckel (14) ist, in dem das verflüssigte Gas (20) die IC-Packung (40,42,44,46) und das in den Becherabschnitten (52) enthaltene Quecksilber (60) bedeckt.

5. Anordnung nach Anspruch 1, 2, 3 oder 4, dadurch gekennzeichnet, daS die Anzahl der elektrischen Anschlußstifte (46) der IC-Packung mindestens 100 beträgt.

6. Anordnung nach Anspruch 5, dadurch gekennzeichnet, daß die Anzahl der elektrischen Anschlußstifte (46) der IC-Packung mindestens 200 beträgt.

7. Anordnung nach einem der vorhergehenden Ansprüche, dadurch gekennzeichnet, daß das verflüssigte Gas wahlweise Stickstoff, Freon, Argon oder Helium ist.

8. Ein Verfahren zum Befestigen einer IC-Packung (40,42,44,46) in einer Packungsanordnung (10) für eine integrierte Schaltung nach einem der Ansprüche 1 bis 7, gekennzeichnet durch Einsetzen jedes Anschlußstiftes (46) der IC-Packung (40,42,44,46) in flüssiges Quecksilber (60), das in dem Becherabschnitt (52) eines jeweiligen Gegenstiftes (50) enthalten ist und Verfestigen des flüssigen Quecksilbers (60) durch Eintauchen der IC-Packung (40,42,44,46) und der Quecksilber enthaltenden Becherabschnitte (52) in dem verflüssigten Gas (20), um jeden Anschlußstift (46) der IC-Packung (40,42,44,46) fest mit einem jeweiligen Gegenstift (50) zu verbinden.

9. Ein Verfahren zum Entfernen einer IC-Packung (40,42,44,46) aus einer Packungsanordnung (10) für einen integrierten Schaltkreis nach einem der Ansprüche 1 bis 7, gekennzeichnet durch Erhöhen der Temperatur innerhalb des Gefäßes (12), um das in jedem Becherabschnitt (52) enthaltene Quecksilber (60) zu verflüssigen, um das Herausziehen jedes Anschlußstiftes (46) der IC-Packung (40,42,44,46) aus dem Becherabschnitt (52) eines jeweiligen Gegenstiftes (50) zu ermöglichen.

## Revendications

1. Ensemble (10) de mise en modules de circuits intégrés comprenant un module (40, 42, 44) de circuits intégrés ayant plusieurs broches électriques (46), un récipient thermique isolant contenant un gaz liquéfié électriquement non conducteur (20) ayant une température inférieure à la température de solidification du mercure, ledit module de circuits intégrés étant immergé dans ledit gaz liquéfié, et des moyens de connexion (54, 56) destinés à coupler électriquement ledit module (40, 42, 44) de circuits à un circuit (80) extérieur audit récipient, et à l'isoler thermiquement dudit circuit (80) extérieur au récipient, lesdits moyens de connexion (54, 56) comprenant une matière électriquement conductrice (54), à faible conductibilité thermique remplissant chacune de plusieurs ouvertures (58) s'étendant à travers ledit récipient (12) et dont le nombre correspond au nombre de broches électriques (46) dudit module (40, 42, 44) de circuits intégrés, plusieurs broches d'accouplement (50) ayant chacune une extrémité plongée dans la matière (54) contenue dans une ouverture respective (58) et une extrémité opposée disposée à l'intérieur dudit récipient 12 et ayant une partie en coupelle (52) recevant l'une, respective, desdites broches électriques (46), lesdites broches électriques (46) étant maintenues dans lesdites parties en coupelle (52) par du mercure solidifié à la basse température dudit gaz liquéfié (20), et plusieurs broches électriquement conductrices (56) de connexion plongées chacune par une extrémité dans ladite matière (54) et faisant saillie vers l'extérieur dudit récipient (12) pour établir un contact dans une douille (70, 72, 74) à réseau quadrillé de broches afin de faciliter la connexion électrique dudit ensemble à circuit intégré sur une plaquette à circuit imprimé.

2. Ensemble selon la revendication 1, caractérisé en ce que ladite matière (54) électriquement conductrice, à basse conductibilité thermique, est du carbone.

3. Ensemble selon la revendication 1 ou 2, caractérisé en ce que ladite douille (70, 72, 74) d'un réseau quadrillé de broches comprend plusieurs broches de réception ayant chacune une partie (72) destinée à recevoir une broche de connexion correspondante (56) et une partie en saillie (74) agencée de façon à être connectée et soudée (82) à des conducteurs respectifs sur ladite plaquette (80) à circuit imprimé.

4. Ensemble selon la revendication 1, 2 ou 3, caractérisé en ce que ledit récipient est un vase de Dewar (12) ayant un dessus amovible (14) et dans lequel ledit gaz liquéfié (20) recouvre ledit module (40, 42, 44, 46) de circuits intégrés et le mercure (60) contenu dans lesdites parties en coupelle (52).

5. Ensemble selon la revendication 1, 2, 3 ou 4, caractérisé en ce que le nombre de broches électriques (46) dudit module de circuits intégrés est d'au moins 100.

6. Ensemble selon la revendication 5, caractérisé en ce que le nombre de broches électriques (46) dudit module de circuits intégrés est d'au moins 200.

7. Ensemble selon l'une quelconque des revendications précédentes, caractérisé en ce que ledit gaz liquéfié est choisi entre de l'azote, du Fréon, de l'argon et de l'hélium.

8. Procédé de montage d'un module (40, 42, 44, 46) de circuits intégrés sur un ensemble (10) de mise en module de circuit intégré selon l'une quelconque des revendications 1 à 7, caractérisé en ce qu'il consiste à insérer chaque broche (46) dudit module (40, 42, 44, 46) de circuits intégrés dans du mercure liquide (60) contenu dans la partie en coupelle (52) d'une broche d'accouplement respective (50), et à solidifier le mercure liquide (60) en immergeant ledit module (40, 42, 44, 46) de circuits intégrés et les parties en coupelle (52) contenant du mercure dans ledit gaz liquéfié (20) afin de lier rigidement chaque broche (46) dudit module (40, 42, 44, 46) de circuits intégrés à une broche d'accouplement respective (50).

9. Procédé pour enlever un module (40, 42, 44, 46) de circuits intégrés d'un ensemble (10) de mise en module de circuits intégrés selon l'une quelconque des revendications 1 à 7, caractérisé en ce qu'il consiste à élever la température à l'intérieur dudit récipient (12) afin de liquéfier le mercure (60) contenu dans chaque partie en coupelle (52) pour permettre à chaque broche (46) dudit module (40, 42, 44, 46) de circuits intégrés d'être enlevée de la partie en coupelle (52) d'une broche d'accouplement respective (50).
